# EUROPEAN PATENT SPECIFICATION

(11) **EP 3 321 785 B1**
(45) Date of publication and mention of the grant of the patent: **18.11.2020**
(21) Application number: 15871295.0
(22) Date of filing: 31.12.2015
(51) Int. Cl.: G06F 3/044, H01L 27/32, G06F 3/041, H01L 51/52

(54) **EMBEDDED TOUCH SCREEN AND ORGANIC LIGHT-EMITTING DIODE DISPLAY DEVICE**
EINGEBETTETER BERÜHRUNGSBILDSCHIRM UND ANZEIGEVORRICHTUNG MIT ORGANISCHEN LEUCHTDIODEN
ÉCRAN TACTILE INTÉGRÉ ET DISPOSITIF D'AFFICHAGE À DIODES ÉLECTROLUMINESCENTES ORGANIQUES

(30) Priority: 06.07.2015 CN 201510389330
(43) Date of publication of application: 16.05.2018
(73) Proprietor: BOE Technology Group Co., Ltd., Beijing Anhui 100015 (CN); Beijing BOE Optoelectronics Technology Co., Ltd., Beijing 100176 (CN)
(72) Inventor: WANG, Lei, Beijing 100176 (CN); CHEN, Xiaochuan, Beijing 100176 (CN); YANG, Shengji, Beijing 100176 (CN); DING, Xiaoliang, Beijing 100176 (CN); LI, Yue, Beijing 100176 (CN); ZHAO, Weijie, Beijing 100176 (CN); XIE, Xiaobo, Beijing 100176 (CN)
(74) Representative: Fritzsche, Thomas
(86) International application number: PCT/CN2015/100124
(87) International publication number: WO 2017/004960

(56) References cited:
- CN-A- 101 894 856
- CN-A- 104 020 892
- CN-A- 104 020 909
- CN-A- 104 020 910
- CN-A- 104 216 564
- CN-A- 104 679 369
- CN-A- 104 698 700
- CN-A- 104 716 144
- CN-A- 104 915 084
- US-A1- 2011 273 397
- US-A1- 2012 306 812
- US-A1- 2014 247 247

## Description

### FIELD

The present disclosure generally relates to the display field, and more specifically to an embedded touch screen and an organic light-emitting diode display device.

### BACKGROUND

Organic light-emitting diode (OLED) display technology, as an extremely promising display technology, has advantages including significantly increased viewing angle, reduced power consumption, improved contrast, decreased screen thickness, fast response time, high luminous efficiency, and the like as compared to the liquid crystal display (LCD) technology, since it employs the mode of self-emitting pixels instead of the common backlight mode.

Touch screen function has become one of the primary forms of modern input modes, which has gradually replaced the traditional mechanical key-press input mode in portable electronic products such as mobile phone, tablet computer, electronic book, and so on, and a full-touch key-free input mode would finally be implemented. It is an advanced technical tend currently to integrate the touch function into a display device.

Touch screens may be divided into a plug-in touch screen, a surface-covered touch screen and an embedded touch screen in terms of the constituent structure, wherein the plug-in touch screen is a liquid crystal display screen having touch function which is formed by producing the touch screen and the liquid crystal display screen separately and then attaching them together. The plug-in touch screen involves disadvantages including high manufacture cost, low light transmittance, relatively thick modules, and the like. In contrast, the embedded touch screen is to embed the touch electrodes of the touch screen within the liquid crystal display screen, which can not only decrease the overall thickness of the modules but also reduce the manufacture cost of the touch screen significantly, hence it is preferred by panel manufacturers.

Currently, the existing embedded touch screen detects the position touched by a finger using the mutual capacitance or self-capacitance principle. Taking the Iphone 5 of Apple Corportation, USA as an example, it employs an embedded touch screen based on mutual capacitance and makes the capacitor electrodes on the array substrate. Relative to conventional array processes, the array process of the embedded touch screen is additionally added with at least two masks and at least two photolithography process steps, resulting in an increase in the manufacture cost.

By comparison, the self-capacitance principle is to arrange in the touch screen a plurality of self-capacitor electrodes which are arranged in the same layer and are insulated from each other. When the human body does not touch the screen, the capacitances on respective self-capacitance electrodes are of a certain fixed value; when the human body touches the screen, the capacitances on corresponding self-capacitance electrodes are of the fixed value plus the capacitance of the human body. A touch detection chip can determine the touch position by detecting variations in the capacitance values of the respective capacitor electrodes during a touch time period. Since the capacitance of the human body can act on all of the self capacitances, as compared to the case that the capacitance of the human body can only act on the projective capacitances in the mutual capacitances, the amount of variation in touch resulting from touching the screen by the human body would be larger than that in the touch screen made using the mutual-capacitance principle. Therefore, the self capacitance-based touch screen can efficiently increase the signal-to-noise ratio of the touch signal as compared to the mutual capacitance-based touch screen, thereby improving the accuracy of touch sensing.

CN 104716144A provides an array substrate, which comprises a base substrate, a plurality of touch electrodes disposed on the base substrate, a plurality of touch electrode leads disposed on the base substrate for leading out signals of the touch electrodes respectively, and an array structure disposed on the base substrate comprising a plurality of conducting structures. In particular, at least part of each touch electrode lead and at least one of the conducting structures are disposed in a same layer and are made from a same material.

CN 104698700A provides a touch display panel, which may include a touch electrode layer disposed above a common electrode layer, where the touch electrode layer comprises multiple touch electrodes and the touch electrodes are metal grid electrodes; and a touch electrode wire layer disposed above the common electrode layer, where the touch electrode wire layer comprises multiple touch electrode wires, an one-to-one correspondence exists between the touch electrode wires and the touch electrodes, and the touch electrode wires are electrically connected to the touch electrodes respectively. In particular, in a case that the touch electrode layer is disposed in the same layer with the touch electrode wire layer, a pixel electrode layer may be disposed in the same layer with the touch electrode layer, to further reduce the thickness of the touch display panel.

CN 104020909A provides an in-cell touch panel, 1, which comprises an array substrate provided with pixel electrodes, and a plurality of self-capacitance electrodes mutually independently arranged in the same layer and disposed on the array substrate. In particular, the overall shape of the self-capacitance electrodes may be set by one or a combination of the following two ways: 1. Both the opposite sides of the two adjacent self-capacitance electrodes, being zigzag lines, may be set to have stepped structures, and the two stepped structures have consistent shape and match with each other; 2. Both the opposite sides of the two adjacent self-capacitance electrodes, being zigzag lines, may be set to have concave-convex structures, and the two concave-convex structures have consistent shape and match with each other. US 2011/273397 A1 relates to an organic EL display device having a pixel circuit on a first substrate and a touch detection circuit adjacent to the pixel circuit on the first substrate.

### SUMMARY

It is one objective of the present disclosure to overcome at least some of the above disadvantages, and to provide an improved embedded touch screen and display device.

In accordance with one aspect of the present disclosure, an embedded touch screen is provided according to claim 1.

The present disclosure achieves the integration of the OLED display with the touch function by integrating the touch technology into an OLED display device. The proposed display device implements the touch functionality based on the self capacitance scheme on the basis of the existing organic light-emitting diode display device, without influencing the pixel characteristics of the display device. The signal-to-noise ratio is significantly increased as compared to the mutual capacitance scheme.

By forming the self-capacitance electrode at an existing gap between anodes, the touch functionality can be implemented on the basis of the existing array substrate manufacturing process, without the need to add additional processes, which can consequently save the production cost and improve the production efficiency.

By setting the opening, the shielding effect of the cathode on the top of the top-emitting structure on the self-capacitance electrode arranged in the same layer as the anode can be eliminated, thereby enhancing the sensitivity to touch.

In accordance with another illustrative embodiment of the present disclosure, opposite sides of two adjacent self-capacitance electrodes may have zigzag shapes.

In the embedded touch screen provided by embodiments of the present disclosure, since the capacitance of the human body acts on the self capacitances of the self-capacitance electrodes by means of direct coupling, when the human body touches the screen, only the capacitance values of the self-capacitance electrodes below the touch position have a relatively large amount of variation, while there is a very small amount of variation in the capacitance values of other self-capacitance electrodes adjacent to the self-capacitance electrodes below the touch position. In this way, when sliding on the touch screen, the touch coordinates of the area where the self-capacitance electrodes are located cannot be determined. Accordingly, the amount of variation in the capacitance values of the self-capacitance electrodes adjacent to the self-capacitance electrodes below the touch position can be increased by setting the opposite sides of two adjacent self-capacitance electrodes to be zigzag.

In accordance with another illustrative embodiment of the present disclosure, opposite sides of two adjacent self-capacitance electrodes may have consistent and matching step shapes.

In accordance with another illustrative embodiment of the present disclosure, opposite sides of two adjacent self-capacitance electrodes may have consistent and matching convex-concave shapes.

In accordance with another illustrative embodiment of the present disclosure, the self-capacitance electrode may be designed as a square electrode of 5 mm^{∗}5mm.

In accordance with another aspect of the present disclosure, a display device is provided, which comprises the above embedded touch screen.

In accordance with illustrative embodiments of the present disclosure, the display device may be a passive matrix organic light-emitting diode display or an active matrix organic light-emitting diode display.

### BRIEF DESCRIPTION OF DRAWINGS

These and other purposes, features and advantages of the present disclosure would become clearer and more apparent from the following detailed description of illustrative embodiments of the present disclosure with reference to the drawings, wherein the drawings are not drawn to scale. In the drawings,
Fig 1 is a structural schematic diagram of an organic light-emitting diode (OLED) device;
Fig 2 is a structural schematic diagram of an embedded touch screen according to illustrative embodiments of the present disclosure;
Fig 3 is a locally enlarged view of the embedded touch screen as shown in Fig 2; and
Figs 4a and 4b are a structural schematic diagram of adjacent self-capacitance electrodes in the embedded touch screens provided by embodiments of the present disclosure, respectively.

### DETAILED DESCRIPTION

Illustrative embodiments of the present disclosure will be described in detail with reference to the drawings. The drawings are schematic, which are not drawn to scale and are just for illustrating the embodiments of the present disclosure rather than limiting the protection scope of the present disclosure. In the drawings, same reference sign denotes the same or similar components. In order to make the technical solutions of the present disclosure clearer, the process steps and device structures well known in the art are omitted herein.

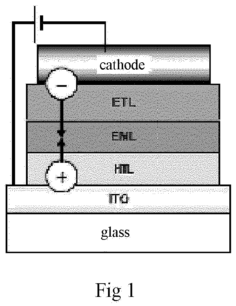

Fig 1 shows a structural schematic diagram of an OLED device. A indium tin oxide (ITO) film is sputtered on a glass substrate as an anode, and a hole transport layer (HTL) and an electron transport layer (ETL) are formed on the anode, between which a light-emitting layer formed by an organic material is sandwiched. Finally, a cathode layer is deposited on the electron transport layer. When the device is applied with an appropriate forward bias voltage, electrons and holes overcome the interface energy barrier and are injected via the cathode and the anode. Electrons are injected into the lowest unoccupied orbital energy level of the electron transport layer via a metal cathode, and holes are injected into the highest occupied orbital energy level of the hole transport layer via a wide bandgap transparent ITO film. Driven by an external electric field, the injected electrons and holes transfer to the light-emitting layer in the electron transport layer and the hole transport layer, which are consequently combined with each other within the organic material with luminescent property to form excitons in excited state. The excitons transfer energy to the organic light-emitting molecules and excite transition of the electrons of the organic light-emitting molecules from the ground state to the excited state, and then excite inactivation of the photoelectron radiation so as to generate photons, release energy and return to the stable ground state.

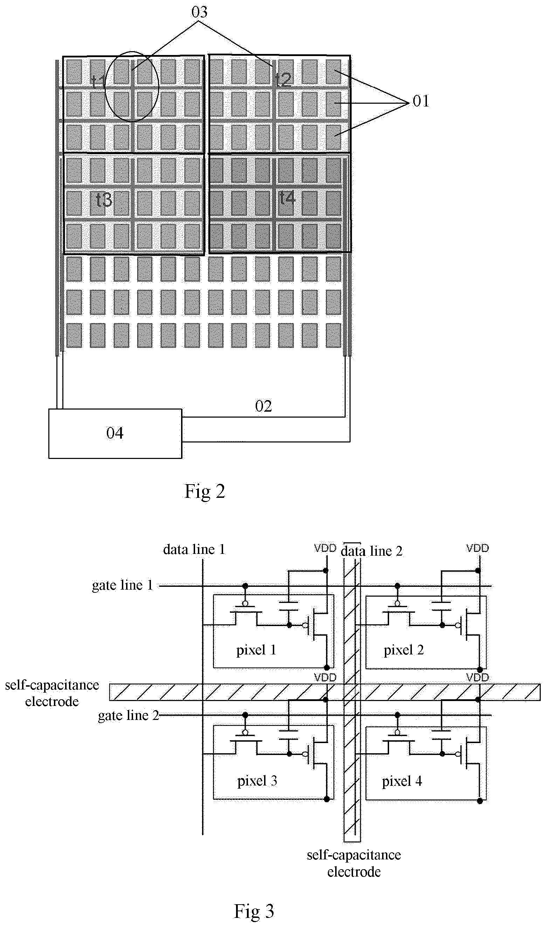

Fig 2 illustrates a structural schematic diagram of an embedded touch screen according to illustrative embodiments of the present disclosure. The embedded touch screen comprises an array substrate having a plurality of subpixels 01, each subpixel 01 comprising an organic light-emitting diode; a plurality of gate lines and data lines (not shown in Fig 2) arranged on the array substrate which intersect each other and are insulated from each other, the gate lines and the data lines intersecting each other to define the plurality of subpixels; a plurality of self-capacitance electrodes 03 which are arranged in the same layer and independent from each other; and a plurality of touch connecting lines 02 for connecting respective self-capacitance electrodes to a touch detection chip 04, wherein the self-capacitance electrodes 03 are arranged in the same layer as anodes of the organic light-emitting diodes. The self-capacitance electrodes are connected to the touch detection chip 04 with wires 02, the self-capacitance electrodes 03 are applied with a driving signal Tx via the touch detection chip 04, and the self-capacitance electrodes 03 may receive feedback signals by themselves. Since during the working process, for example, a finger for operation employs the manner of direct coupling, the amount of variation in touch caused by the finger would be relatively large.

Fig 2 schematically illustrates four self-capacitance electrode patterns t1-t4. Specifically, the anodes of the organic light-emitting diodes are of discrete structure, each anode corresponds to one subpixel 01, and each self-capacitance electrode is arranged at a gap between adjacent anodes to form a grid pattern surrounding the anodes of the organic light-emitting diodes. As shown in Fig 2, the self-capacitance electrode patterns t1-t4 include row-column network structures formed between 6^{∗}3 subpixels 01, and t1-t4 are connected to the touch detection chip 04 respectively via the touch connecting lines 02. The touch functionality can be implemented on the basis of the existing array substrate manufacturing process by forming the self-capacitance electrodes at an existing gap between the anodes of adjacent organic light-emitting diodes, without the need to add additional processes, thus the production cost can be saved and the production efficiency can be improved.

It is to be noted that although Fig 2 shows the subpixels as rectangles with the same size, those skilled in the art can design the subpixels and corresponding anodes of the organic light-emitting diodes to have different shapes based on practical needs. In addition, the self-capacitance electrodes may be arranged at other positions in the layer where the anodes of the organic light-emitting diodes are located, rather than being limited to the gaps between anodes. Moreover, the pattern of the self-capacitance electrodes is not limited to the grid pattern, either, but any pattern arranged in the same layer as the anodes of the organic light-emitting diodes may be employed, e.g. polygon, annular shape, etc.

When the organic light-emitting diode is a top-emitting structure, the cathode is located at the top, thus it would produce shielding effect on the self-capacitance electrode below it. In order to eliminate the shielding effect, an opening may be arranged in the area where the cathode of the organic light-emitting diode overlaps the self-capacitance electrode.

Fig 3 illustrates a locally enlarged view of the embedded touch screen in the circle portion as shown in Fig 2. Fig 3 shows the portions (shadow portions) between four subpixels 1-4 of the self-capacitance electrode pattern t1 (Fig 2), wherein the plurality of gate lines and data lines arranged on the array substrate which intersect each other and are insulated from each other define a plurality of subpixels.

In the embedded touch screen provided by embodiments of the present disclosure, since the capacitance of the human body acts on the self capacitances of the self-capacitance electrodes by means of direct coupling, when the human body touches the screen, only the capacitance values of the self-capacitance electrodes below the touch position have a relatively large amount of variation, while there is a very small amount of variation in the capacitance values of other self-capacitance electrodes adjacent to the self-capacitance electrodes below the touch position. In this way, when sliding on the touch screen, the touch coordinates of the area where the self-capacitance electrodes are located cannot be determined. Accordingly, the amount of variation in the capacitance values of the self-capacitance electrodes adjacent to the self-capacitance electrodes below the touch position can be increased by setting the opposite sides of two adjacent self-capacitance electrodes to be zigzag.

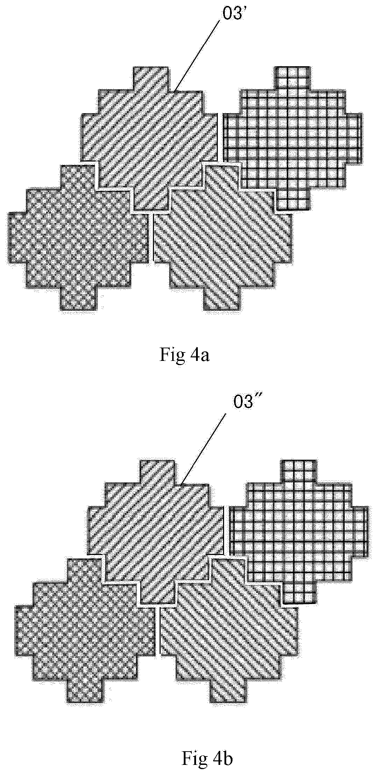

A macro overall shape of the plurality of self-capacitance electrodes may be set in the manner as follows. In Fig 4a, opposite sides of two adjacent self-capacitance electrodes are set as a step shape, and adjacent step shapes are consistent and match each other. Fig 4a shows 2^{∗}2 self-capacitance electrodes 03'. Alternatively, in Fig 4b, opposite sides of two adjacent self-capacitance electrodes are both set as a convex-concave shape, and adjacent convex-concave shapes are consistent and match each other. Fig 4b shows 2^{∗}2 self-capacitance electrodes 03". It is to be noted that although the self-capacitance electrodes are illustrated in Figs 4a and 4b as squares whose sides have a zigzag shape, they are just exemplary. The self-capacitance electrodes may have other macro overall shapes, wherein opposite sides of adjacent self-capacitance electrodes 03 have a zigzag shape. In Figs 4a and 4b, adjacent self-capacitance electrodes do not contact each other.

Generally, the density of the touch detection is usually at millimeter scale. Therefore, the density of the self-capacitance electrodes and the area occupied by them can be selected based on a required touch detection density in order to ensure the required touch detection density. For example, the self-capacitance electrode may be designed as a square electrode of about 5 mm^{∗}5mm. Since the density of the display screen is usually at micrometer scale, one self-capacitance electrode would generally correspond to a plurality of subpixels in the display screen.

The touch detection chip is used to determine the touch position by detecting variations in the capacitance values of the respective self-capacitance electrodes during the touch time period. The touch detection chip is manufactured using, for example, an integrated circuit (IC) technology. Furthermore, during specific implementation, arrangement of the touch connecting lines can be adjusted according to specific schemes.

On the basis of the same concept, embodiments of the present disclosure further provide a display device comprising the above embedded touch screen as provided. The display device may be a passive matrix organic light-emitting diode (PMOLED) display, wherein the substrate needs an external driving circuit, or may be an active matrix organic light-emitting diode (AMOLED) display, wherein the driving circuit and the display array are integrated on the same substrate.

The display device may be any product or component having display function such as mobile phone, tablet computer, television, display, notebook computer, digital frame, watch, navigator, and so on. The proposed display device implements the touch functionality based on the self capacitance scheme on the basis of the existing organic light-emitting diode display device, without influencing the pixel characteristics of the display device. The signal-to-noise ratio is significantly increased as compared to the mutual capacitance scheme.

Although the illustrative embodiments of the present disclosure have been described in detail with reference to the drawings, such description should be considered to be illustrative or exemplary, rather than limiting. The present disclosure is not limited to the embodiments disclosed.

In the claims, the word "comprise" does not exclude the existence of other components or steps, and "a" or "an" does not exclude the plural. The fact that several technical measures are stated in different dependent claims does not mean that the combination of these technical measures cannot be advantageously utilized.

## Claims

1. An embedded touch screen, comprising:
an array substrate having a plurality of subpixels (01), each subpixel (01) comprising an organic light-emitting diode;
a plurality of gate lines and data lines arranged on the array substrate which intersect each other and are insulated from each other, the gate lines and the data lines intersecting each other to define the plurality of subpixels;
a plurality of self-capacitance electrodes (03) which are arranged in the same layer and independent from each other; and
a plurality of touch connecting lines (02) for connecting respective self-capacitance electrodes (03) to a touch detection chip (04),
wherein the self-capacitance electrodes (03) are arranged in the same layer as anodes of organic light-emitting diodes,
the organic light-emitting diode is a top-emitting structure, and
a cathode of the organic light-emitting diode has an opening in an area where it overlaps the self-capacitance electrode (03),
wherein the anodes of organic light-emitting diodes are of discrete structure, each anode corresponding to one subpixel (01), and each self-capacitance electrode (03) is arranged at a gap between adjacent anodes,
wherein a pattern of the self-capacitance electrodes (03) is designed as a grid pattern surrounding the anodes of organic light-emitting diodes.

2. The embedded touch screen according to claim 1, wherein opposite sides of two adjacent self-capacitance electrodes (03) have zigzag shapes.

3. The embedded touch screen according to claim 2, wherein opposite sides of two adjacent self-capacitance electrodes (03) have consistent and matching step shapes.

4. The embedded touch screen according to claim 2, wherein opposite sides of two adjacent self-capacitance electrodes (03) have consistent and matching convex-concave shapes.

5. The embedded touch screen according to claim 1, wherein the self-capacitance electrode (03) is designed as a square electrode of 5 mm^{∗}5mm.

6. A display device, **characterized in that**, the display device comprises the embedded touch screen according to any one of claims 1 to 5.

7. The display device according to claim 6, wherein the display device is a passive matrix organic light-emitting diode display or an active matrix organic light-emitting diode display.

## Patentansprüche

1. Eingebetteter Berührungsbildschirm, umfassend:
ein Arraysubstrat, das eine Vielzahl von Subpixeln (01) aufweist, wobei jedes Subpixel (01) eine organische Leuchtdiode umfasst;
eine Vielzahl von auf dem Arraysubstrat angeordneten Gateleitungen und Datenleitungen, die einander schneiden und voneinander isoliert sind, wobei die Gateleitungen und die Datenleitungen einander schneiden, um die Vielzahl von Subpixeln zu definieren;
eine Vielzahl von Eigenkapazitätselektroden (03), die in derselben Schicht angeordnet und voneinander unabhängig sind; und
eine Vielzahl von Berührungsverbindungsleitungen (02) zum Verbinden der jeweiligen Eigenkapazitätselektroden (03) mit einem Berührungserfassungschip (04),
wobei
die Eigenkapazitätselektroden (03) in derselben Schicht wie Anoden organischer Leuchtdioden angeordnet sind,
die organische Leuchtdiode eine nach oben emittierende Struktur ist, und
eine Kathode der organischen Leuchtdiode über eine Öffnung in einem Bereich verfügt, in dem sie die Eigenkapazitätselektrode (03) überlappt,
wobei die Anoden der organischen Lichtdioden aus einer diskreten Struktur bestehen, wobei jede Anode einem Subpixel (01) entspricht und jede Eigenkapazitätselektrode (03) in einem Spalt zwischen benachbarten Anoden angeordnet ist,
wobei ein Muster der Eigenkapazitätselektroden (03) als Gittermuster ausgestaltet ist, das die Anoden organischer Leuchtdioden umgibt.

2. Eingebetteter Berührungsbildschirm nach Anspruch 1, wobei gegenüberliegende Seiten von zwei benachbarten Eigenkapazitätselektroden (03) Zickzackformen aufweisen.

3. Eingebetteter Berührungsbildschirm nach Anspruch 2, wobei gegenüberliegende Seiten von zwei benachbarten Eigenkapazitätselektroden (03) konsistente und übereinstimmende Stufenformen aufweisen.

4. Eingebetteter Berührungsbildschirm nach Anspruch 2, wobei gegenüberliegende Seiten von zwei benachbarten Eigenkapazitätselektroden (03) konsistente und übereinstimmende konvex-konkave Formen aufweisen.

5. Eingebetteter Berührungsbildschirm nach Anspruch 1, wobei die Eigenkapazitätselektrode (03) als quadratische Elektrode von 5 mm * 5 mm ausgestaltet ist.

6. Anzeigevorrichtung, **dadurch gekennzeichnet, dass** die Anzeigevorrichtung den eingebetteten Berührungsbildschirm nach einem der Ansprüche 1 bis 5 umfasst.

7. Anzeigevorrichtung nach Anspruch 6, wobei die Anzeigevorrichtung eine Passivmatrixanzeige mit organischen Leuchtdioden oder eine Aktivmatrixanzeige mit organischen Leuchtdioden ist.

## Revendications

1. Écran tactile intégré, comprenant :
un substrat de réseau ayant une pluralité de sous-pixels (01), chaque sous-pixel (01) comprenant une diode électroluminescente organique ;
une pluralité de lignes de grille et de lignes de données disposées sur le substrat de réseau qui se croisent et sont isolées les unes des autres, les lignes de grille et les lignes de données se croisant pour définir la pluralité de sous-pixels ;
une pluralité d'électrodes à capacité propre (03) qui sont disposées dans la même couche et indépendantes les unes des autres ; et
une pluralité de lignes de connexion tactile (02) pour connecter des électrodes à capacité propre (03) respectives à une puce de détection tactile (04),
dans lequel
les électrodes à capacité propre (03) sont disposées dans la même couche que les anodes de diodes électroluminescentes organiques,
la diode électroluminescente organique est une structure émettant par le haut, et
une cathode de la diode électroluminescente organique présente une ouverture dans une zone où elle chevauche l'électrode à capacité propre (03),
dans lequel les anodes de diodes électroluminescentes organiques sont de structure discrète, chaque anode correspondant à un sous-pixel (01), et chaque électrode à capacité propre (03) est disposée au niveau d'un écartement entre des anodes adjacentes, dans lequel un motif des électrodes à capacité propre (03) est conçu comme un motif de grille entourant les anodes de diodes électroluminescentes organiques.

2. Écran tactile intégré selon la revendication 1, dans lequel les côtés opposés de deux électrodes à capacité propre (03) adjacentes ont des formes en zigzag.

3. Écran tactile intégré selon la revendication 2, dans lequel les côtés opposés de deux électrodes à capacité propre (03) adjacentes ont des formes étagées cohérentes et correspondantes.

4. Écran tactile intégré selon la revendication 2, dans lequel les côtés opposés de deux électrodes à capacité propre (03) adjacentes ont des formes concaves-convexes cohérentes et correspondantes.

5. Écran tactile intégré selon la revendication 1, dans lequel l'électrode à capacité propre (03) est conçue comme une électrode carrée de 5 mm*5 mm.

6. Dispositif d'affichage, **caractérisé en ce que**, le dispositif d'affichage comprend l'écran tactile intégré selon l'une quelconque des revendications 1 à 5.

7. Dispositif d'affichage selon la revendication 6, dans lequel le dispositif d'affichage est un affichage à diode électroluminescente organique à matrice passive ou un affichage à diode électroluminescente organique à matrice active.
